# FASCICULE DE BREVET EUROPEEN

(11) **EP 3 196 667 B1**
(45) Date de publication et mention de la délivrance du brevet: **11.09.2019**
(21) Numéro de dépôt: 17152278.2
(22) Date de dépôt: 19.01.2017
(51) Int. Cl.: G01S 7/03, G01S 7/02, H03G 11/02, G01S 7/34, H04B 1/16

(54) **DISPOSITIF RÉCEPTEUR DE SIGNAL RADIOFRÉQUENCE IMPULSIONNEL**
EMPFÄNGERVORRICHTUNG FÜR FUNKFREQUENZ-IMPULSSIGNAL
RECEIVING DEVICE FOR IMPULSIONAL RADIOFREQUENCY SIGNALS

(30) Priorité: 22.01.2016 FR 1600113
(43) Date de publication de la demande: 26.07.2017
(73) Titulaire: Thales, 92400 Courbevoie (FR)
(72) Inventeur: GARREC, Patrick, 33608 Pessac Cedex (FR); CORNIC, Pascal, 29238 Brest Cedex 3 (FR); MALLET-GUY, Benoit, 78851 Elancourt (FR)
(74) Mandataire: Lavoix

(56) Documents cités:
- EP-A1- 1 431 772
- US-A- 5 010 341
- US-A- 5 300 900
- US-B1- 6 181 744

## Description

La présente invention concerne un dispositif récepteur de signal radiofréquence impulsionnel, comportant un filtre de détection d'amplitude comportant au moins un composant électronique semi-conducteur de détection.

L'invention se situe dans le domaine technique de la réception de signaux impulsionnels de grande dynamique, permettant de capter l'environnement radioélectrique d'un porteur du récepteur.

De tels récepteurs de signaux radiofréquence sont notamment utilisés dans le domaine des télécommunications militaires, en particulier dans les radars détecteurs d'alerte (RWR pour « radar warning receiver ») ou dans le domaine des mesures de support électronique.

On connaît des dispositifs récepteurs à composant électronique semi-conducteur de détection formé par une diode de détection Schottky ou une diode à Arséniure de Gallium (AsGa) polarisée.

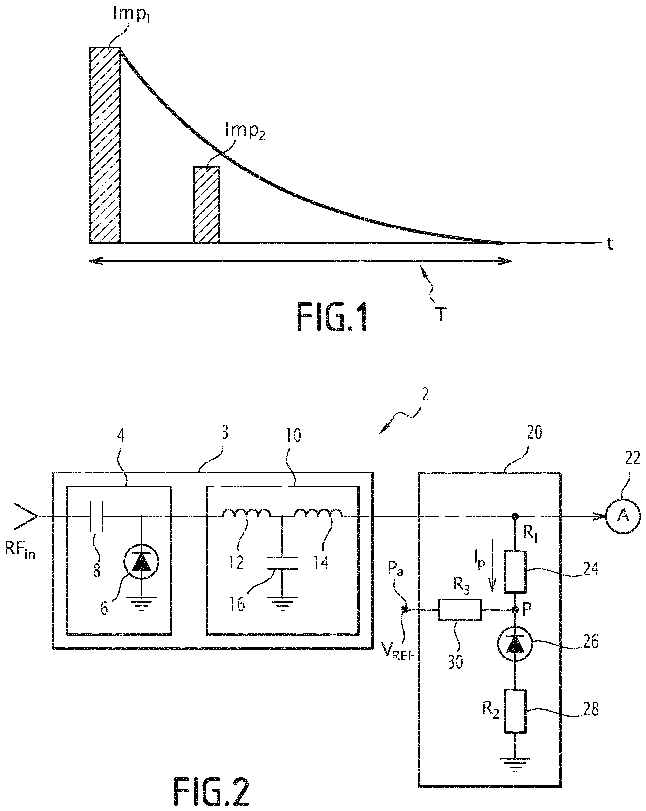

Lors de la réception de signaux de forte amplitude, le composant électronique semi-conducteur de détection subit une saturation, ce qui induit un temps de recouvrement T avant de revenir à un fonctionnement de détection nominal. Le temps de recouvrement est dépendant du niveau du signal radiofréquence reçu et la décroissance de ce temps de désaturation est exponentielle, comme illustré à titre d'exemple dans la figure 1, qui représente le niveau de détection en fonction du temps de recouvrement du composant électronique semi-conducteur de détection, à partir d'une impulsion Imp₁ de forte amplitude qui provoque une saturation du composant électronique de détection, suivie d'une deuxième impulsion Imp₂ de faible amplitude.

Pendant le temps de recouvrement, le fonctionnement du composant électronique semi-conducteur de détection est perturbé, pour la détection d'une deuxième impulsion de forte amplitude suivant de près une première impulsion de forte amplitude, ainsi que pour la détection d'une impulsion de faible amplitude suivant une impulsion de forte amplitude, pendant la période de recouvrement.

Pendant la période de recouvrement, les impulsions de signaux radiofréquence sont soit masquées, donc non détectées, soit détectées avec une déformation de la forme du signal.

Il existe des méthodes complexes consistant à prendre en compte les déformations induites dans la détection des impulsions pendant la période de recouvrement.

Le document EP 1 431 772 A1 décrit un limiteur de puissance de signal hyperfréquence, qui s'applique dans le domaine des radars fonctionnant en bande S.

Le document US 5 010 341 A décrit un dispositif limiteur haute fréquence présentant un temps de recouvrement réduit.

L'invention a pour but de remédier à la perturbation de réception décrite ci-dessus.

A cet effet, suivant un premier aspect, l'invention propose un dispositif récepteur de signal radiofréquence impulsionnel, comportant un filtre de détection d'amplitude comportant au moins un composant électronique semi-conducteur de détection et un filtre comportant un composant capacitif. Conformément à l'invention il comporte un circuit de désaturation, branché en sortie du filtre de détection d'amplitude, le circuit de désaturation étant adapté à drainer un courant électrique dudit composant capacitif lorsqu'une grandeur physique mesurée parmi le courant ou la tension du signal radiofréquence dépasse une valeur de référence prédéterminée,
ledit composant électronique semi-conducteur de détection comportant une première zone de fonctionnement quadratique caractérisée par une première tension de seuil, et au moins une deuxième zone de fonctionnement linéaire caractérisée par une deuxième tension de seuil supérieure à la première tension de seuil,
ladite valeur de référence prédéterminée étant choisie en fonction de la première tension de seuil et/ou de la deuxième tension de seuil.

Le dispositif récepteur de signal radiofréquence impulsionnel selon l'invention permet avantageusement, grâce au circuit de désaturation, de réduire considérablement le temps de recouvrement du composant électronique semi-conducteur de détection.

Dans des modes de réalisation, le dispositif récepteur de signal radiofréquence impulsionnel suivant l'invention comporte en outre une ou plusieurs des caractéristiques suivantes.

Le dispositif récepteur de signal radiofréquence comporte un circuit de désaturation, branché en sortie du filtre de détection d'amplitude, le circuit de désaturation étant adapté à drainer un courant électrique dudit composant capacitif lorsqu'une grandeur physique mesurée parmi le courant ou la tension du signal radiofréquence dépasse une valeur de référence prédéterminée, ledit composant électronique semi-conducteur de détection comportant une première zone de fonctionnement quadratique caractérisée par une première tension de seuil, et au moins une deuxième zone de fonctionnement linéaire caractérisée par une deuxième tension de seuil supérieure à la première tension de seuil, ladite valeur de référence prédéterminée étant choisie en fonction de la première tension de seuil et la deuxième tension de seuil.

La valeur de référence prédéterminée est une valeur de tension prédéterminée et le circuit de désaturation est alimenté par une tension d'alimentation choisie en fonction de ladite valeur de tension prédéterminée.

La valeur de référence prédéterminée est une valeur de tension prédéterminée comprise entre la première tension de seuil et la deuxième tension de seuil.

La valeur de tension prédéterminée est égale à ladite première tension de seuil.

Le composant électronique semi-conducteur de détection est une diode de détection de type Schottky ou à Arséniure de Gallium polarisée, et le circuit de désaturation comprend une diode de désaturation de même type que la diode de détection.

La diode de désaturation et la diode de détection ont des caractéristiques de tension de seuil et de courant de saturation identiques.

Le circuit de désaturation comprend un premier composant résistif branché en série avec ladite diode de désaturation, un deuxième composant résistif branché en série entre la diode de désaturation et un point neutre.

Le circuit de désaturation comprend un troisième composant résistif, branché en parallèle entre un point situé entre le premier composant résistif, la diode de désaturation et l'alimentation du circuit de désaturation.

Le premier composant résistif a une valeur de résistance calculée pour obtenir une valeur prédéterminée d'intensité de courant de polarisation de la diode de détection.

Ledit filtre comprend deux composants inductifs branchés en série, ledit composant capacitif étant branché en parallèle entre les deux composants inductifs.

Des caractéristiques et avantages de l'invention ressortiront de la description qui en est donnée ci-dessous, à titre indicatif et nullement limitatif, en référence aux figures annexées, parmi lesquelles :
- la figure 1, déjà décrite, représente schématiquement le niveau de détection atteignable pendant un temps de recouvrement par un composant électronique de détection ;
- la figure 2 représente schématiquement un dispositif de réception selon un mode de réalisation de l'invention ;
- la figure 3 représente des zones de fonctionnement d'une diode de détection ;
- la figure 4 représente schématiquement le temps de recouvrement et le niveau de détection atteignable dans un dispositif récepteur implémentant l'invention ;
- la figure 5 représente des profils d'amplitude de signal radiofréquence détecté sans et avec un circuit de désaturation selon l'invention.

L'invention sera décrite ci-après dans le cas d'un dispositif récepteur comportant un composant électronique semi-conducteur de détection qui est une diode de détection.

La figure 2 illustre schématiquement un mode de réalisation d'un dispositif de réception 2 de signaux radiofréquence impulsionnels RF selon un mode de réalisation.

Le dispositif 2 comprend un filtre de détection d'amplitude 3, composé d'un détecteur de signal radiofréquence 4 et d'un filtre 10.

Le détecteur 4 comprend un composant électronique semi-conducteur de détection 6.

Dans le mode de réalisation de la figure 2, le composant électronique semi-conducteur de détection 6 est une diode de détection, de préférence une diode Schottky.

En alternative d'autres types de diodes peuvent être utilisées comme les diodes PN ou PIN (pour « Positive Intrinsic Negative »).

La composante continue du signal radiofréquence RF_{IN} est supprimée via un composant capacitif 8 de capacité C₁, en sortie duquel est branchée la diode de détection 6.

La diode de détection 6 redresse le signal radiofréquence RF_{IN}.

Lorsque la tension du signal radiofréquence RF_{IN} est supérieure à la tension de seuil de la diode de détection 6, la diode 6 est passante et le signal radiofréquence est transmis à un filtre 10, qui effectue un filtrage en bande de base, laissant passer un signal radiofréquence de fréquence comprise entre 0 et Fₘₐₓ, la fréquence Fₘₐₓ, de l'ordre de quelques Mégahertz, étant dépendante des valeurs des composants du filtre 10.

Dans le mode de réalisation de la figure 2, le filtre 10 est un filtre dit en T, comprenant deux composants inductifs 12 et 14, d'inductances respectives L₁ et L₂, montés en série, et un composant capacitif 16 de capacité C₂, branché entre les deux composants inductifs 12 et 14 et la masse.

Un circuit de désaturation 20 est monté en sortie du filtre 10, et permet de fournir un signal électrique de sortie de tension Vₒᵤₜ à un amplificateur 22 branché en sortie du dispositif de réception 2.

Le circuit de désaturation 20 comprend, dans le mode de réalisation illustré, un premier composant résistif 24, de résistance R₁, branché entre la sortie du filtre 10 et un point de connexion P.

En série avec le composant résistif 24 est branchée une deuxième diode 26, dite diode de désaturation, laquelle est branchée en série avec un deuxième composant résistif 28 de résistance R₂, branché entre la diode de désaturation 26 et la masse.

La diode de désaturation 26 est du même type que la diode de détection 6, et possède les mêmes caractéristiques de tension de seuil, appelée également tension de coude, et de courant de saturation.

Un troisième composant résistif 30 est branché entre un point d'alimentation Pₐ et le point de connexion P, une tension d'alimentation de référence V_{REF} étant fournie au point d'alimentation Pₐ.

Lorsque la diode de détection 6 est polarisée, un courant de polarisation I_{P} passe par le premier composant résistif 24. Par exemple, I_{P} est de 100 µA (micro-ampères),

Par exemple, une valeur de tension d'alimentation de référence V_{REF} de -2,5 Volts alimente le troisième composant résistif 30, la tension d'alimentation de référence étant choisie de manière à générer une source de courant dans la diode de désaturation 26.

La valeur de résistance R₂ est choisie pour générer une tension V_{P} égale à la tension de seuil de la diode de détection 6, permettant de figer le courant de polarisation I_{P}. Par exemple, V_{P}=200mV (millivolts).

En l'absence de la diode de désaturation 26, le composant capacitif 16 se décharge dans le composant résistif 24 avec une constante de temps T₀ donnée, par exemple T₀=100ns (nanosecondes).

Dans ce cas, la charge et la décharge du composant 16 sont des exponentielles croissantes et décroissantes tant qu'on reste dans une zone de fonctionnement quadratique de la diode de détection 6.

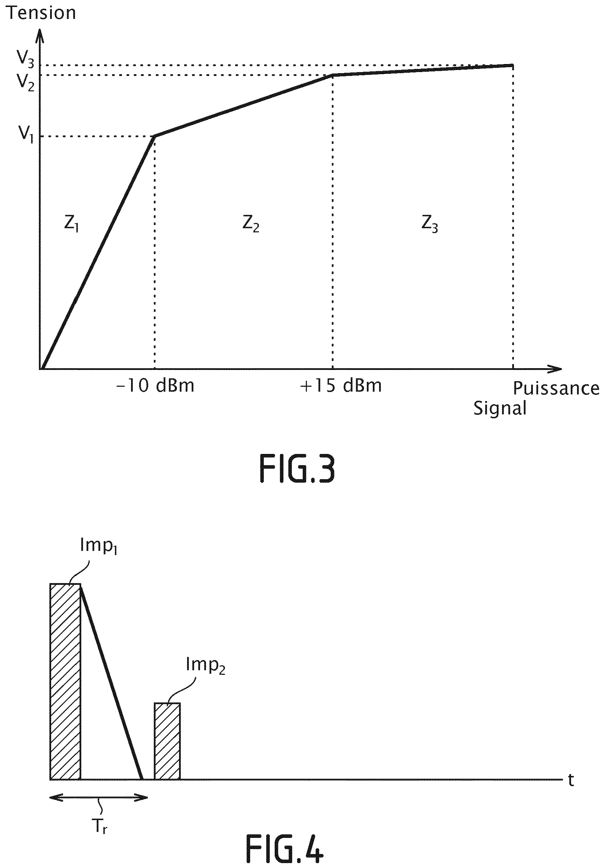

Par exemple, la figure 3 illustre schématiquement, dans un graphe G, les trois zones de fonctionnement, notées Z₁, Z₂, Z₃, d'une diode de détection, en fonction de la puissance du signal radiofréquence à détecter exprimée en dBm.

La première zone Z₁ est une zone de fonctionnement quadratique, tant que le niveau puissance du signal radiofréquence détecté est inférieur à un premier seuil S₁, avec *S*₁ = -10*dBm* dans l'exemple illustré, correspondant à une première tension de seuil V₁.

Dans la zone Z₁ de fonctionnement quadratique, la charge et la décharge du composant capacitif 16 sont exponentielles selon une première pente donnée, le fonctionnement est nominal et rapide.

La première pente est illustrée dans la zone Z₁ du graphe G de la figure 3.

En cas de signal de niveau de puissance supérieur au premier seuil, égal à -10 dBm dans l'exemple, la vitesse de décharge de la capacité 16 est réduite par la diode 6 qui se trouve dans sa zone linéaire.

La deuxième zone de fonctionnement Z₂ est une zone de fonctionnement linéaire, tant que le niveau de puissance du signal radiofréquence détecté est compris entre le premier seuil S₁ et un deuxième seuil S₂, avec *S*₂ =15*dBm* dans l'exemple illustré, correspondant à une deuxième tension de seuil V₂.

Dans la zone de fonctionnement linéaire Z₂, la charge et la décharge du composant capacitif 16 sont linéaires selon une deuxième pente donnée, plus faible que la première pente de charge et décharge exponentielles de la première zone de fonctionnement.

La troisième zone de fonctionnement Z₃ est une zone de fonctionnement en saturation, pour un niveau de puissance du signal radiofréquence RF_{IN} supérieur au deuxième seuil S₂.

Dans la zone de fonctionnement en saturation Z₃, la charge et la décharge du composant capacitif 16 sont linéaires selon une troisième pente donnée, plus faible que la deuxième pente, le temps de charge ou de décharge est par conséquent long.

De préférence, les valeurs R₁, R₂, R₃ et V_{REF} sont choisies de manière à ce que lorsque l'impulsion du signal radiofréquence RF_{IN} a une tension supérieure à une valeur de référence prédéterminée, la tension V_{P} est supérieure à la tension de seuil de la diode de désaturation 26 et la diode de désaturation 26 devient passante.

Dans un mode de réalisation, la valeur de référence prédéterminée est égale à la première tension de seuil V₁ de basculement entre la zone de fonctionnement quadratique Z₁ et la zone de fonctionnement linéaire Z₂.

En alternative, la valeur de référence prédéterminée est une tension prédéterminée comprise entre V₁ et V₂.

Les tensions V₁, V_{P} sont liées par une relation linéaire, et il en est de même des tensions V_{REF} et V_{P}.

Dans l'exemple de réalisation de la figure 2, les diodes 6 et 26 possèdent les mêmes caractéristiques, comme indiqué ci-dessus.

La valeur R₁ de la résistance 24 est calculée pour obtenir une valeur prédéterminée d'intensité pour le courant de polarisation de la diode de détection 6.

La valeur R₂ de la résistance 28 est calculée selon la valeur du courant passant dans la résistance 24 (de valeur R₁) afin de générer un décalage de tension voulu, afin de décaler la tension de seuil de la diode de désaturation 26 pour un décalage adéquat des zones de fonctionnement des diodes 6 et 26.

La résistance 30 a une forte valeur (valeur R₃) afin de transformer la source de tension en source de courant.

La diode de désaturation 26 devient passante, la source de courant se transforme en source de tension et la décroissance de la charge du composant capacitif 16 est accélérée. Par conséquent, le composant capacitif 16 se décharge en un temps plus court, ce qui a pour effet de diminuer le temps de recouvrement de la diode de détection 6.

La figure 4 illustre schématiquement le niveau de détection atteignable pendant un temps de recouvrement Tᵣ de la diode de détection lorsqu'un circuit de désaturation 20 tel que décrit ci-dessus est intégré dans le dispositif récepteur 2.

En comparaison avec la figure 1, on constate dans la figure 4 que le temps de recouvrement est raccourci ce qui permet la détection d'une deuxième impulsion Imp₂ de faible amplitude, qui suit une première impulsion Imp₁ de forte amplitude après un temps t supérieur au temps de recouvrement Tᵣ.

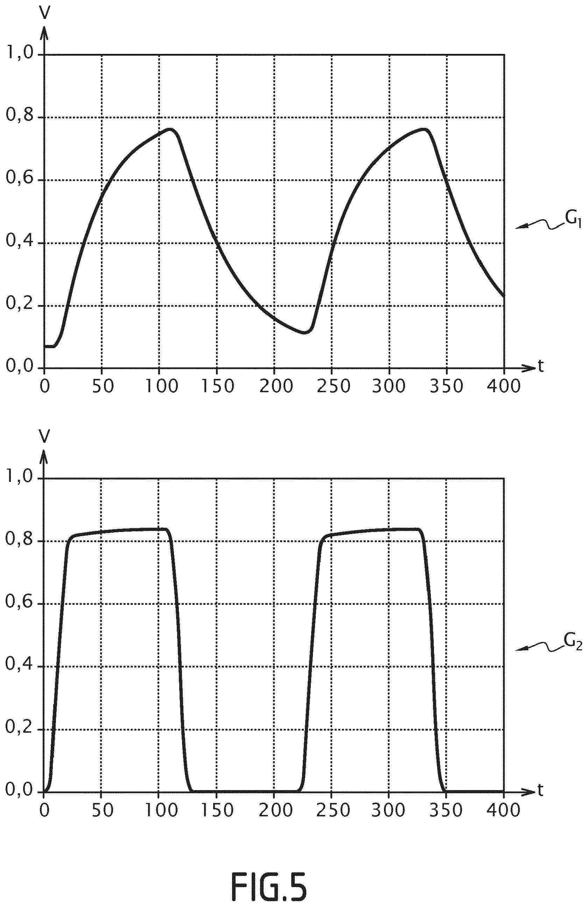

La figure 5 est un exemple illustrant l'enveloppe de la tension de sortie du filtre 10. Le graphe G₁ représente l'enveloppe de tension en sortie du filtre 10 en fonction du temps, en l'absence de circuit de désaturation, alors que le graphe G₂ représente l'enveloppe de tension en sortie du filtre 10 en fonction du temps, en présence du circuit de désaturation 20.

Le graphe G₁ montre la déformation de l'amplitude des impulsions détectées. Grâce à l'utilisation du circuit de désaturation 20, les impulsions détectées représentées dans le graphe G₂ ont une forme quasi dépourvue de déformations.

Avantageusement, le mode de réalisation décrit ci-dessus en référence à la figure 2 permet de réaliser un circuit de désaturation avec un nombre minimal de composants électroniques. Le coût de réalisation est faible, et un tel circuit est facile à réaliser.

Selon des variantes, il est possible de réaliser un circuit de désaturation apte à réaliser la fonctionnalité de décharge rapide du composant capacitif du filtre en utilisant par exemple un comparateur de tension à la place d'une tension de référence, ou avec un système à base de transistors à effet de champ, de type MOSFET.

L'invention a été décrite ci-dessus dans un mode de réalisation dans lequel le circuit de désaturation est mis en oeuvre lorsque la tension du signal radiofréquence dépasse valeur de tension de référence. Il va de soi que l'invention peut être mise en oeuvre également en considérant une valeur de courant de référence.

Plus généralement, l'invention décrite fonctionne avec une valeur de référence prédéterminée, qui est soit une valeur prédéterminée de tension, soit une valeur prédéterminée de courant.

## Revendications

1. Dispositif récepteur de signal radiofréquence impulsionnel, comportant un filtre de détection d'amplitude (3) comportant au moins un composant électronique semi-conducteur de détection (6) et un filtre (10) comportant un composant capacitif (16), **caractérisé en ce qu'**il comporte un circuit de désaturation (20), branché en sortie du filtre (3) de détection d'amplitude, le circuit de désaturation (20) étant adapté à drainer un courant électrique dudit composant capacitif (16) lorsqu'une grandeur physique mesurée parmi le courant ou la tension du signal radiofréquence (RFᵢₙ) dépasse une valeur de référence prédéterminée,
ledit composant électronique semi-conducteur de détection (6) comportant une première zone de fonctionnement quadratique (Z₁) **caractérisée par** une première tension de seuil (V₁), et au moins une deuxième zone de fonctionnement linéaire (Z₂) **caractérisée par** une deuxième tension de seuil (V₂) supérieure à la première tension de seuil (V₁),
ladite valeur de référence prédéterminée étant choisie en fonction de la première tension de seuil (V₁) et/ou de la deuxième tension de seuil (V₂).

2. Dispositif récepteur selon la revendication 1, **caractérisé en ce que** la valeur de référence prédéterminée est une valeur de tension prédéterminée et **en ce que** le circuit de désaturation (20) est alimenté par une tension d'alimentation (V_{REF}) choisie en fonction de ladite valeur de tension prédéterminée.

3. Dispositif récepteur selon l'une des revendications 1 ou 2, **caractérisé en ce que** la valeur de référence prédéterminée est une valeur de tension prédéterminée comprise entre la première tension de seuil et la deuxième tension de seuil.

4. Dispositif récepteur selon la revendication 3, **caractérisé en ce que** la valeur de tension prédéterminée est égale à ladite première tension de seuil (V₁).

5. Dispositif récepteur selon l'une quelconque des revendications 1 à 4, **caractérisé en ce que** le composant électronique semi-conducteur de détection (6) est une diode de détection de type Schottky ou à Arséniure de Gallium polarisée, et **en ce que** le circuit de désaturation (20) comprend une diode de désaturation (26) de même type que la diode de détection (6).

6. Dispositif récepteur selon la revendication 5, **caractérisé en ce que** la diode de désaturation (26) et la diode de détection (6) ont des caractéristiques de tension de seuil et de courant de saturation identiques.

7. Dispositif récepteur selon l'une des revendications 5 ou 6, **caractérisé en ce que** le circuit de désaturation (20) comprend un premier composant résistif (24) branché en série avec ladite diode de désaturation (26), un deuxième composant résistif (28) branché en série entre la diode de désaturation (26) et un point neutre.

8. Dispositif récepteur selon la revendication 7, **caractérisé en ce que** le circuit de désaturation (20) comprend un troisième composant résistif (30), branché en parallèle entre un point situé entre le premier composant résistif (24), la diode de désaturation (26) et une alimentation du circuit de désaturation (20).

9. Dispositif récepteur selon l'une des revendications 7 ou 8, **caractérisé en ce que** le premier composant résistif (24) a une valeur de résistance (R₁) calculée pour obtenir une valeur prédéterminée d'intensité de courant de polarisation de la diode de détection (6).

10. Dispositif récepteur selon l'une quelconque des revendications 1 à 9, **caractérisé en ce que** ledit filtre (10) comprend deux composants inductifs (12, 14) branchés en série, ledit composant capacitif (16) étant branché en parallèle entre les deux composants inductifs.

## Patentansprüche

1. Empfängervorrichtung für ein Impuls-Funkfrequenzsignal, aufweisend ein Amplitudendetektionsfilter (3), welches mindestens eine elektronische Halbleiter-Detektionskomponente (6) und ein Filter (10), welches eine kapazitive Komponente (16) aufweist, aufweist, **dadurch gekennzeichnet, dass** sie einen Entsättigungsschaltkreis (20) aufweist, welcher am Ausgang des Amplitudendetektionsfilters (3) angeschlossen ist, wobei der Entsättigungsschaltkreis (20) angepasst ist, um einen elektrischen Strom der besagten kapazitiven Komponente (16) abzuführen, wenn eine gemessene physikalische Größe von dem Strom oder der Spannung des Funkfrequenzsignals (RFᵢₙ) einen vorbestimmten Referenzwert überschreitet,
wobei die besagte elektronische Halbleiter-Detektionskomponente (6) eine erste quadratische Betriebszone (Z₁), die durch eine erste Schwellenspannung (V₁) gekennzeichnet ist, und mindestens eine zweite lineare Betriebszone (Z₂), die durch eine zweite Schwellenspannung (V₂) gekennzeichnet ist, die größer als die erste Schwellenspannung (V₁) ist, aufweist,
wobei der besagte vorbestimmte Referenzwert abhängig von der ersten Schwellenspannung (V₁) und/oder der zweiten Schwellenspannung (V₂) ausgewählt ist.

2. Empfängervorrichtung gemäß dem Anspruch 1, **dadurch gekennzeichnet, dass** der vorbestimmte Referenzwert ein vorbestimmter Spannungswert ist, und dadurch, dass der Entsättigungsschaltkreis (20) mittels einer Versorgungsspannung (V_{REF}) versorgt wird, die abhängig von dem besagten vorbestimmten Spannungswert ausgewählt ist.

3. Empfängervorrichtung gemäß einem der Ansprüche 1 oder 2, **dadurch gekennzeichnet, dass** der vorbestimmte Referenzwert ein vorbestimmter Spannungswert ist, welcher zwischen der ersten Schwellenspannung und der zweiten Schwellenspannung enthalten ist.

4. Empfängervorrichtung gemäß dem Anspruch 3, **dadurch gekennzeichnet, dass** der vorbestimmte Spannungswert gleich der besagten ersten Schwellenspannung (V₁) ist.

5. Empfängervorrichtung gemäß irgendeinem der Ansprüche 1 bis 4, **dadurch gekennzeichnet, dass** die elektronische Halbleiter-Detektionskomponente (6) eine Detektionsdiode vom Schottky-Typ oder mit polarisiertem Galliumarsenid ist, und dadurch, dass der Entsättigungsschaltkreis (20) eine Entsättigungsdiode (26) vom gleichen Typ wie die Detektionsdiode (6) aufweist.

6. Empfängervorrichtung gemäß dem Anspruch 5, **dadurch gekennzeichnet, dass** die Entsättigungsdiode (26) und die Detektionsdiode (6) identische Schwellenspannungs- und Sättigungsstromcharakteristiken haben.

7. Empfängervorrichtung gemäß einem der Ansprüche 5 oder 6, **dadurch gekennzeichnet, dass** der Entsättigungsschaltkreis (20) eine erste Widerstandskomponente (24), die in Reihe mit der besagten Entsättigungsdiode (26) geschaltet ist, und eine zweite Widerstandskomponente (28), die in Reihe zwischen der Entsättigungsdiode (26) und einem neutralen Punkt geschaltet ist, aufweist.

8. Empfängervorrichtung gemäß dem Anspruch 7, **dadurch gekennzeichnet, dass** der Entsättigungsschaltkreis (20) eine dritte Widerstandskomponente (30) aufweist, die in einem Punkt, der sich zwischen der ersten Widerstandskomponente (24), der Entsättigungsdiode (26) und einer Versorgung des Entsättigungsschaltkreises (20) befindet, parallel geschaltet ist.

9. Empfängervorrichtung gemäß einem der Ansprüche 7 oder 8, **dadurch gekennzeichnet, dass** die erste Widerstandskomponente (24) einen Widerstandswert (R₁) hat, der berechnet ist, um einen vorbestimmten Polarisationsstromstärke-Wert der Detektordiode (6) zu erlangen.

10. Empfängervorrichtung gemäß irgendeinem der Ansprüche 1 bis 9, **dadurch gekennzeichnet, dass** das besagte Filter (10) zwei induktive Komponenten (12, 14) aufweist, die in Reihe geschaltet sind, wobei die besagte kapazitive Komponente (16) parallel zwischen den beiden induktiven Komponenten geschaltet ist.

## Claims

1. Receiving device for a pulsed radiofrequency signal, comprising an amplitude detection filter (3) having at least one electronic semiconductor detection component (6) and a filter (10) having a capacitive component (16), **characterised in that** it comprises a desaturation circuit (20) connected at the output of the amplitude detection filter (3), the desaturation circuit (20) being adapted to drain an electric current from said capacitive component (16) when a measured physical quantity from among the current or the voltage of the radiofrequency signal (RFᵢₙ) exceeds a predetermined reference value,
said electronic semiconductor detection component (6) having a first quadratic operating zone (Z₁) **characterised by** a first threshold voltage (V₁), and at least a second linear operating zone (Z₂) **characterised by** a second threshold voltage (V₂) greater than the first threshold voltage (V₁),
said predetermined reference value being chosen as a function of the first threshold voltage (V₁) and/or of the second threshold voltage (V₂).

2. Receiving device according to claim 1, **characterised in that** the predetermined reference value is a predetermined voltage value, and **in that** the desaturation circuit (20) is supplied with a supply voltage (V_{REF}) chosen as a function of said predetermined voltage value.

3. Receiving device according to either claim 1 or claim 2, **characterised in that** the predetermined reference value is a predetermined voltage value between the first threshold voltage and the second threshold voltage.

4. Receiving device according to claim 3, **characterised in that** the predetermined voltage value is equal to said first threshold voltage (V₁).

5. Receiving device according to any one of claims 1 to 4, **characterised in that** the electronic semiconductor detection component (6) is a detection diode of the Schottky or polarised gallium arsenide type, and **in that** the desaturation circuit (20) comprises a desaturation diode (26) of the same type as the detection diode (6).

6. Receiving device according to claim 5, **characterised in that** the desaturation diode (26) and the detection diode (6) have identical threshold voltage and saturation current characteristics.

7. Receiving device according to either claim 5 or claim 6, **characterised in that** the desaturation circuit (20) comprises a first resistive component (24) connected in series with said desaturation diode (26), a second resistive component (28) connected in series between the desaturation diode (26) and a neutral point.

8. Receiving device according to claim 7, **characterised in that** the desaturation circuit (20) comprises a third resistive component (30) connected in parallel between a point situated between the first resistive component (24), the desaturation diode (26) and a power supply for the desaturation circuit (20).

9. Receiving device according to either claim 7 or claim 8, **characterised in that** the first resistive component (24) has a resistance value (R₁) which is calculated in order to obtain a predetermined polarisation current intensity value of the detection diode (6).

10. Receiving device according to any one of claims 1 to 9, **characterised in that** said filter (10) comprises two inductive components (12, 14) connected in series, said capacitive component (16) being connected in parallel between the two inductive components.
